# EUROPEAN PATENT SPECIFICATION

(11) **EP 4 187 614 B1**
(45) Date of publication and mention of the grant of the patent: **22.10.2025**
(21) Application number: 21855413.7
(22) Date of filing: 03.08.2021
(51) Int. Cl.: H10D 30/47, H10D 30/01, H10D 62/10, H10D 62/17

(54) **HYBRID GATE FIELD EFFECT TRANSISTOR AND MANUFACTURING METHOD THEREFOR, AND SWITCH CIRCUIT**
HYBRID-GATE-FELDEFFEKTTRANSISTOR UND HERSTELLUNGSVERFAHREN DAFÜR SOWIE SCHALTKREIS
TRANSISTOR À EFFET DE CHAMP À GRILLE HYBRIDE ET SON PROCÉDÉ DE FABRICATION, ET CIRCUIT DE COMMUTATEUR

(30) Priority: 10.08.2020 CN 202010795268
(43) Date of publication of application: 31.05.2023
(73) Proprietor: Huawei Technologies Co., Ltd., Shenzhen, Guangdong 518129 (CN)
(72) Inventor: LUO, Ruihong, Shenzhen, Guangdong 518129 (CN); HUANG, Boning, Shenzhen, Guangdong 518129 (CN); SUN, Hui, Shenzhen, Guangdong 518129 (CN); JIANG, Qimeng, Shenzhen, Guangdong 518129 (CN); BAO, Qilong, Shenzhen, Guangdong 518129 (CN); CHEN, Zhibin, Shenzhen, Guangdong 518129 (CN)
(74) Representative: Epping - Hermann - Fischer
(86) International application number: PCT/CN2021/110379
(87) International publication number: WO 2022/033360

(56) References cited:
- WO-A1-2018/230136
- CN-A- 106 298 907
- CN-A- 106 783 962
- CN-A- 109 742 142
- CN-A- 110 299 407
- CN-A- 110 299 407
- US-A- 5 161 235
- US-A1- 2011 147 837
- US-A1- 2015 270 202
- US-A1- 2016 380 091
- US-A1- 2020 119 178

## Description

### TECHNICAL FIELD

This application relates to a hybrid gate field effect transistor, a method for preparing the hybrid gate field effect transistor, and a switch circuit.

### BACKGROUND

Afield effect transistor is widely used in various scenarios as an element of a circuit switch. A field effect transistor with a GaN (gallium nitride)-based material has high mobility and high chemical stability due to the characteristic of the material, and can be used as a higher frequency switch.

The GaN field effect transistor is switched on/off by controlling on/off of two-dimensional electron gas of a channel. GaN field effect transistors are usually divided into two types. One is normally on field effect transistors, also referred to as depletion mode field effect transistors. The other is normally off field effect transistors, also referred to as enhancement mode field effect transistors. However, for the safety of a power consumption system, a switch device is usually required to be normally off. At present, there are several ways to realize the normally off device.

A GaN field effect transistor provided in the conventional technology includes a source, a drain, a gate structure, and a gate metal layer. In use, the gate structure is supplied with power by using the gate metal layer, and the conduction of the source and the drain is controlled by using the gate structure. However, the gate metal layer is usually in Schottky contact with the gate structure, and the Schottky junction may fail due to long-term thermal electron bombardment. This results in low reliability of the GaN field effect transistor.

US 2016/380091 A1 discloses a nitride semiconductor device including a first nitride semiconductor layer, a second nitride semiconductor layer located on the first nitride semiconductor layer and having a band gap larger than a band gap of the first nitride semiconductor layer, a p-type semiconductor layer located on the second nitride semiconductor layer, and a gate electrode located on the p-type semiconductor layer. A first interface and a second interface are located in parallel between the gate electrode and the p-type semiconductor layer. The first interface has a first barrier with respect to holes moving in a direction from the p-type semiconductor layer to the gate electrode. The second interface has a second barrier with respect to the holes moving in a direction from the p-type semiconductor layer to the gate electrode. The second barrier is higher than the first barrier.
US 2020/119178 A1 discloses a nitride semiconductor device including a substrate, a first nitride semiconductor layer disposed above the substrate, a second nitride semiconductor layer disposed above the first nitride semiconductor layer and having a band gap larger than a band gap of the first nitride semiconductor layer, a third nitride semiconductor layer selectively disposed above the second nitride semiconductor layer and containing a p-type first impurity element, a high resistance region disposed in the third nitride semiconductor layer, the high resistance region containing a second impurity element and having a specific resistance higher than a specific resistance of the third nitride semiconductor layer, and a gate electrode disposed above the high resistance region, wherein an end of the high resistance region is inside a surface end of the third nitride semiconductor layer.
CN 110 299 407 A discloses a power device and a preparation method thereof, which relate to the field of semiconductor integrated circuits. The power device includes a substrate arranged in the lowest layer, a buffer layer arranged on one side of the substrate, a barrier layer arranged on the other side of the buffer layer relative to the substrate, and a composite gate structure, wherein the barrier layer and the buffer layer form a heterojunction structure, the composite gate structure includes a gate electrode arranged on one side of the barrier layer relative to the buffer layer and a gate layer arranged between the gate electrode and the barrier layer, and the gate layer includes two regions with different doping concentration.

### SUMMARY

This application provides a hybrid gate field effect transistor, a method for preparing the hybrid gate field effect transistor, and a switch circuit, so as to improve reliability of a hybrid gate field effect transistor. Embodiments of the present invention are defined by the appended claims.

According to a first aspect, a hybrid gate field effect transistor, as defined in claim 1, is provided. The hybrid gate field effect transistor is applied to a switch circuit, is used as a main device of the switch circuit, and is configured to control switch-on and switch-off of the switch circuit. The hybrid gate field effect transistor includes a channel layer, and a source, a drain, and a gate structure that are stacked with the channel layer. The source, the drain, and the gate structure are disposed in a same layer, and the gate structure is located between the source and the drain. In this application, the gate structure is a hybrid gate structure prepared from two materials. Specifically, the gate structure includes a first structural layer and a second structural layer. The first structural layer and the second structural layer are disposed in a same layer, and the first structural layer and the second structural layer are separately connected to the channel layer. In addition, the second structural layer wraps the first structural layer when disposed. The first structural layer is located in the middle of the gate structure, and the second structural layer is located on the periphery of the gate structure. In this application, the first structural layer is an N-type gallium nitride layer or an intrinsic gallium nitride layer; and the second structural layer is a P-type gallium nitride layer. The hybrid gate field effect transistor further includes a gate metal layer. The gate metal layer is disposed on one side of the gate structure facing away from the channel layer, and the gate metal layer is in ohmic contact with the first structural layer. It can be learned from the foregoing description that, in a manner of using the hybrid gate structure as the gate structure, the gate structure is prepared by using two different materials, and the material located in the middle of the hybrid gate is in ohmic contact with the gate metal layer, to improve reliability of connection between the gate metal layer and the gate structure, thereby improving reliability of the hybrid gate field effect transistor.

In a specific implementable solution, the channel layer includes a gallium nitride layer and an aluminum gallium nitride barrier layer that are stacked; and the source, the drain, and the gate structure are disposed on the aluminum gallium nitride barrier layer. A channel is formed between the gallium nitride layer and the aluminum gallium nitride barrier layer by using the gallium nitride layer and the aluminum gallium nitride barrier layer.

In a specific implementable solution, a substrate, and a buffer layer disposed on the substrate are further included. The gallium nitride layer is formed on the buffer layer. By using the disposed buffer layer, the gallium nitride layer can be carried on the substrate.

In a specific implementable solution, a material of the substrate can be silicon, sapphire, silicon carbide, or a gallium nitride material. The substrate may be prepared by using different materials.

In a specific implementable solution, a passivation layer is further included, and the passivation layer and the aluminum gallium nitride barrier layer are stacked; and the source, the drain, and the gate structure run through the passivation layer, and are exposed outside the passivation layer. A structural layer of the hybrid gate field effect transistor is protected by using the passivation layer.

In a specific implementable solution, the first structural layer is cylindrical, square columnar, or cylindroid. A shape of the first structural layer may be selected to be different.

In a specific implementable solution, there may be at least one first structural layer. For example, there may be one, two, three, or more first structural layers.

In a specific implementable solution, when there are a plurality of first structural layers, the plurality of first structural layers may be arranged in one row, in an array, or in another arrangement manner.

According to the invention, the gate metal layer is in Schottky contact with the second structural layer. The gate metal layer is connected to the first structural layer and the second structural layer of the gate structure respectively in two different connection manners.

According to a second aspect, a method for preparing a hybrid gate field effect transistor, as defined in claim 7, is provided
The method includes the following steps:
forming a first structural layer and a second structural layer on a channel layer, where the first structural layer and the second structural layer are disposed in a same layer, and the second structural layer wraps the first structural layer; and the first structural layer and the second structural layer form a gate structure; and
forming a source and a drain on the channel layer.

It can be learned from the foregoing description that, in a manner of using the hybrid gate structure as the gate structure, the gate structure is prepared by using two different materials, and the material located in the middle of the hybrid gate is in ohmic contact with the gate metal layer, to improve reliability of connection between the gate metal layer and the gate structure, thereby improving reliability of the hybrid gate field effect transistor.

In a specific implementable solution, the forming a first structural layer and a second structural layer on a channel layer is specifically: forming an etching layer on the channel layer; etching an annular hole in the etching layer; forming the second structural layer in the annular hole; etching a through hole in the etching layer, where an inner side wall of the second structural layer is a side wall of the through hole; forming the first structural layer in the through hole, where the second structural layer wraps the first structural layer; and etching off a remaining part of the etching layer. The gate structure is formed in an etching manner.

In a specific implementable solution, the forming a first structural layer and a second structural layer on a channel layer is specifically: forming an etching layer on the channel layer; etching a through hole in the etching layer; forming the first structural layer in the through hole; etching an annular hole in the etching layer, where an outer side wall of the first structural layer is exposed outside the annular hole; and forming the second structural layer in the annular hole, where the second structural layer wraps the first structural layer; and etching off a remaining part of the etching layer. The gate structure is formed in an etching manner.

In a specific implementable solution, the forming a first structural layer and a second structural layer on a channel layer is specifically: forming, on the channel layer, a material layer with a same material as that of the first structural layer; etching the material layer to form the first structural layer; and forming the second structural layer through ion injection, where the second structural layer wraps the first structural layer. The gate structure is formed in a manner of ion injection.

In a specific implementable solution, the forming a first structural layer and a second structural layer on a channel layer is specifically: forming, on the channel layer, a material layer with a same material as that of the second structural layer; etching the material layer to form the second structural layer; and forming the first structural layer through ion injection, where the second structural layer wraps the first structural layer. The gate structure is formed in a manner of ion injection.

In a specific implementable solution, the method further includes: forming a buffer layer on a substrate; and forming the channel layer on the buffer layer.

According to a third aspect, a switch circuit is provided. The switch circuit includes a mainboard and the hybrid gate field effect transistor according to any one of the foregoing implementations that is disposed on the mainboard. It can be learned from the foregoing description that, in a manner of using the hybrid gate structure as the gate structure, the gate structure is prepared by using two different materials, and the material located in the middle of the hybrid gate is in ohmic contact with the gate metal layer, to improve reliability of connection between the gate metal layer and the gate structure, thereby improving reliability of the hybrid gate field effect transistor.

### BRIEF DESCRIPTION OF DRAWINGS

FIG. 1 is a schematic diagram of a structure of a hybrid gate field effect transistor according to an embodiment of this application;
FIG. 2 is a top view of a gate structure of a hybrid gate field effect transistor according to an embodiment of this application;
FIG. 3 is another top view of a gate structure of a hybrid gate field effect transistor according to an embodiment of this application;
FIG. 4 is another top view of a gate structure of a hybrid gate field effect transistor according to an embodiment of this application;
FIG. 5a to FIG. 5g are flowcharts for preparing a hybrid gate field effect transistor according to an embodiment of this application;
FIG. 6a to FIG. 6g are other flowcharts for preparing a hybrid gate field effect transistor according to an embodiment of this application;
FIG. 7a to FIG. 7d are flowcharts for preparing a hybrid gate field effect transistor according to an embodiment of this application; and
FIG. 8a to FIG. 8d are other flowcharts for preparing a hybrid gate field effect transistor according to an embodiment of this application.

### DESCRIPTION OF EMBODIMENTS

The following further describes embodiments of this application with reference to the accompanying drawings.

First, a hybrid gate field effect transistor provided in embodiments of this application is described. A field effect transistor is widely used in various scenarios as an element of a circuit switch. A field effect transistor with a GaN (gallium nitride)-based material has high mobility and high chemical stability due to the characteristic of the material, can be used as a higher frequency switch, and therefore, is widely used in a high-frequency circuit switch.

The GaN field effect transistor is switched on/off by controlling on/off of two-dimensional electron gas of a channel. GaN field effect transistors are usually divided into two types. One is normally on field effect transistors, also referred to as depletion mode field effect transistors. The other is normally off field effect transistors, also referred to as enhancement mode field effect transistors. However, for the safety of a power consumption system, a switch device is usually required to be normally off. At present, there are several ways to realize the normally off device. However, in a current GaN field effect transistor, a gate metal and a gate structure are usually connected in a manner of a Schottky junction, but the Schottky junction may fail due to long-term thermal electron bombardment. This results in low reliability. In view of this, an embodiment of this application provides a hybrid gate field effect transistor used to improve reliability of a field effect transistor. The following describes the hybrid gate field effect transistor in detail with reference to specific accompanying drawings and embodiments.

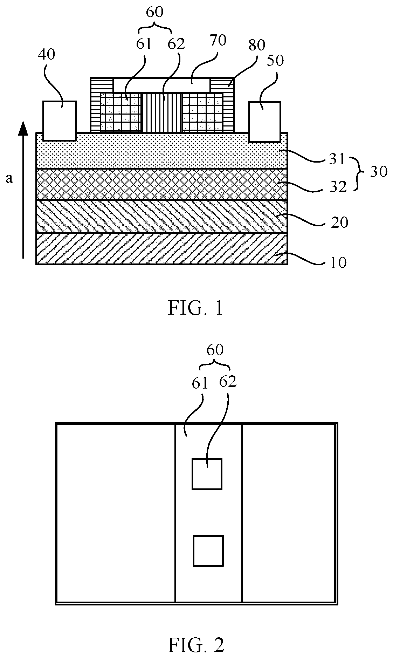

FIG. 1 is a schematic diagram of structural layers of a hybrid gate field effect transistor according to an embodiment of this application. The hybrid gate field effect transistor provided in this embodiment of this application includes a plurality of stacked structural layers. For ease of description, a placement direction of the hybrid gate field effect transistor shown in FIG. 1 is used as a reference direction. The hybrid gate field effect transistor includes a substrate 10, a buffer layer 20, a channel layer 30, a source 40, a drain 50, and a structural layer 60 that are arranged in sequence in a direction a. The following describes the foregoing structural layers in detail with reference to specific accompanying drawings.

The substrate 10 is a basic component of the hybrid gate field effect transistor, and is configured to carry various functional layers of the hybrid gate field effect transistor. When specifically disposed, the substrate 10 may be prepared by using different materials, provided that the substrate 10 has a particular supporting strength. For example, the substrate 10 may be a structural layer prepared by using different materials such as silicon, sapphire, silicon carbide, or gallium nitride. The substrate 10 may be prepared by using different materials.

In an optional solution, a rectangular structural layer may be selected for the substrate 10. However, it should be understood that the shape of the substrate 10 provided in this embodiment of this application is not limited to the rectangular structure, but may be alternatively another different shape, such as an ellipse or a polygon, provided that the substrate 10 has a sufficient area to carry other functional layers of the hybrid gate field effect transistor.

The buffer layer 20 is disposed on the substrate 10, and may be specifically formed on a surface of the substrate 10 by using processes such as chemical vapor deposition and epitaxial growth. The buffer layer 20 is used as an optional structural layer. The buffer layer 20 may be disposed as required during arrangement. For example, when the substrate 10 can directly carry the channel layer 30, the buffer layer 20 may not be disposed, and the channel layer 30 may be directly formed on the substrate 10. When a material of the channel layer 30 conflicts with that of the substrate 10, and the channel layer 30 cannot be directly formed on the substrate 10, the buffer layer 20 is disposed to isolate the substrate 10 from the channel layer 30. In this case, the buffer layer 20 is used as a carrier layer of the channel layer 30. When the buffer layer 20 carries the channel layer 30, on one hand, the buffer layer 20 may be used as a structural layer for carrying the channel, and on the other hand, the buffer layer 20 further has particular elastic deformation performance. The channel layer 30 disposed on a surface of the buffer layer 20 can be protected by using the buffer layer 20, so that reliability and safety of the hybrid gate field effect transistor provided in this embodiment of this application are improved.

In an optional solution, the buffer layer 20 may be a structural layer prepared by using different materials such as gradient aluminum gallium nitride, superlattice, and low-temperature aluminum nitride. When the hybrid gate field effect transistor is specifically prepared, different materials may be selected based on requirements, to prepare the buffer layer 20.

The channel layer 30 is a functional layer of the hybrid gate field effect transistor, and is configured to form two-dimensional electron gas of the hybrid gate field effect transistor. In an optional solution, the channel layer 30 includes a gallium nitride layer 32 and an aluminum gallium nitride barrier layer 31 that are stacked in the direction a. A channel may be formed on a contact surface between the gallium nitride layer 32 and the aluminum gallium nitride barrier layer 31, and the two-dimensional electron gas is located on the contact surface between the gallium nitride layer 32 and the aluminum gallium nitride barrier layer 31.

When the channel layer 30 is specifically disposed, the gallium nitride layer 32 may be disposed on the buffer layer 20, for example, may be directly formed on the buffer layer 20 by using a process such as etching or ion injection. When the substrate 10 can directly carry the channel layer 30, the gallium nitride layer 32 may be directly prepared on the substrate 10 by using a process such as etching or ion injection. The aluminum gallium nitride barrier layer 31 is disposed on a surface of the gallium nitride layer 32 facing away from the substrate 10. During preparation, the aluminum gallium nitride barrier layer 31 may also be prepared by using the foregoing process such as etching or ion injection.

In addition to the foregoing structure, the channel layer 30 may also use another structure. For example, the channel layer 30 includes a three-layer structure, including a gallium nitride layer, an aluminum gallium nitride barrier layer, and an aluminum nitride layer located between the gallium nitride layer and the aluminum gallium nitride barrier layer. A channel may also be formed by using a three-layer structure.

The source-drain layer is a functional layer of the hybrid gate field effect transistor, and includes a source 40, a drain 50, and a gate structural layer 60. As shown in FIG. 1, the source 40, the gate structural layer 60, and the drain 50 are disposed in a same layer on the channel layer 30 and are electrically connected to the channel layer 30. The source 40 and the drain 50 are separately configured to connect to an external circuit, and the gate structural layer 60 is configured to control opening and closing of the channel. When the gate structural layer 60 controls channel conduction, the hybrid gate field effect transistor is in a closed state, and the circuit connected to the source 40 and the drain 50 can be conducted. When the gate structural layer 60 controls channel disconnection, the hybrid gate field effect transistor is in a disconnected state, and the circuit connected to the source 40 and the drain 50 is disconnected.

The gate structural layer 60, the source 40, and the drain 50 are separately connected to the aluminum gallium nitride barrier layer 31, and the source 40 and the drain 50 may communicate with the channel by using the aluminum gallium nitride barrier layer 31. The gate structural layer 60 may be connected to the channel by using the aluminum gallium nitride barrier layer 31 and may deplete electrons located in the channel. When the gate structural layer 60 controls the channel conduction, electrons are located in the channel, and the source 40 and the drain 50 may conduct by using the electrons in the channel. When the gate structural layer 60 controls the channel disconnection, the electrons are depleted by the gate structural layer 60, there are no free electrons in the channel, and the source 40 and the drain 50 are disconnected.

When the source 40, the drain 50, and the gate structural layer 60 are specifically disposed, the gate structural layer 60 is located between the source 40 and the drain 50 and separates the source 40 from the drain 50. It should be understood that, when the gate structural layer 60, the drain 50, and the source 40 are specifically disposed, a gap is spaced between the gate structural layer 60 and the source 40 and the drain 50, to ensure electrical isolation between the gate structural layer 60 and the source 40 and the drain 50.

The gate structural layer 60 provided in this embodiment of this application uses a hybrid gate structure, and the hybrid gate structure is formed of two materials. The gate structural layer 60 includes a first structural layer 62 and a second structural layer 61. The first structural layer 62 and the second structural layer 61 are disposed in a same layer, and the first structural layer 62 and the second structural layer 61 are separately connected to the channel layer 30. In this embodiment of this application, the first structural layer 62 and the second structural layer 61 are prepared by using different materials. The first structural layer 62 is an N-type gallium nitride layer, and the second structural layer 61 is a P-type gallium nitride layer. The hybrid gate structure may be composed of the following materials: P-type gallium nitride + N-type gallium nitride; or P-type gallium nitride + intrinsic gallium nitride. During specific preparation, any combination may be selected based on a requirement, to prepare the hybrid gate structure.

The hybrid gate field effect transistor further includes a gate metal layer 70. The gate metal layer 70 is configured to connect to the gate structural layer 60 and configured to apply a control voltage to the gate structural layer 60 for controlling channel opening and closing.

Still referring to FIG. 1, the gate metal layer 70 is stacked with the gate structural layer 60 and is located on a surface of the gate structural layer 60 facing away from the channel layer 30. For ease of description, the surface of the gate structural layer 60 facing away from the channel layer 30 is referred to as a top surface of the gate structural layer 60. On the top surface of the gate structural layer 60, the first structural layer 62 is exposed outside the second structural layer 61, that is, the top surface of the gate structural layer 60 is composed of a surface of the first structural layer 62 and a surface of the second structural layer 61. When the gate structural layer 60 is connected to the gate metal, the top surface of the gate structural layer 60 is a surface on which the gate structural layer 60 is connected to the gate metal layer 70. When connected to the gate structural layer 60, the gate metal layer 70 is in ohmic contact with the first structural layer 62. The gate metal layer 70 may be prepared by using a common conductive metal material such as copper, aluminum, titanium, nickel, chromium, or gold. The first structural layer 62 uses an N-type gallium nitride layer, the gate metal layer 70 is directly in ohmic contact with it. Forming the ohmic contact between the metal and the semiconductor means that a pure resistance is formed at the contact point, and the smaller the resistance is, the better, so that when the component is operated, most of the voltage is applied to the active region and not to the contact surface. In addition, the ohmic contact does not have long-term thermal electron bombardment, and the reliability is high. By using the ohmic contact between the gate metal layer 70 and the gate structural layer 60, reliability of connection between the gate metal layer 70 and the gate structural layer 60 is improved, and reliability of the hybrid gate field effect transistor is further improved.

The gate metal layer 70 is in ohmic contact with the first structural layer 62:
The gate metal layer 70 is in ohmic contact with only the first structural layer 62. The ohmic contact between the gate metal layer 70 and the first structural layer 62 enables the current of the gate metal layer 70 to be better applied to the first structural layer 62.

The gate metal layer 70 is in ohmic contact with the first structural layer 62, and the gate metal layer 70

is in Schottky contact with the second structural layer 61. The gate metal layer 70 is connected to the first structural layer 62 and the second structural layer 61 of the gate structural layer 60 respectively in two different connection manners. Although the gate metal layer 70 is in separate contact with the first structural layer 62 and the second structural layer 61 in different manners to implement electrical connection, the voltage is still applied to the gate structural layer 60 through the ohmic contact because the resistance of the Schottky contact is high.

The hybrid gate field effect transistor further includes a passivation layer 80, and the passivation layer 80 is configured to protect each functional layer in the hybrid gate field effect transistor. During the arrangement, the passivation layer 80 and the aluminum gallium nitride barrier layer 31 are stacked. It should be understood that, to ensure that the source 40, the drain 50, and the gate structural layer 60 can be connected to the external circuit and the control circuit, when the foregoing structures are disposed, the source 40, the drain 50, and the gate structural layer 60 run through the passivation layer 80 and are exposed outside the passivation layer 80. The exposed parts of the source 40, the drain 50, and the gate structural layer 60 may be used for connection to the external circuit and the control circuit.

In an optional solution, the passivation layer 80 may be prepared by using silicon nitride, aluminum oxide, silicon oxynitride, or other common materials.

It should be understood that, the passivation layer 80 is an optional structural layer of the hybrid gate field effect transistor. When an application environment of the hybrid gate field effect transistor is relatively safe, the passivation layer 80 may not be disposed.

When the first structural layer 62 and the second structural layer 61 are specifically prepared, the first structural layer 62 is located in the middle of the gate structural layer 60, the second structural layer 61 is located on the periphery of the gate structural layer 60, and the second structural layer 61 wraps the first structural layer 62.

However, the first structural layer 62 may use different shapes and structures. The following describes specific structural forms of the first structural layer 62 and the second structural layer 61 with reference to the accompanying drawings.

FIG. 2 shows a top view of a gate structural layer. The second structural layer 61 wraps the first structural layer 62, the first structural layer 62 is located in the middle of the gate structural layer 60, and the second structural layer 61 is located on the periphery of the gate structural layer 60. There are two first structural layers 62, and each first structural layer 62 is a rectangular structure. When the two first structural layers 62 are specifically disposed, the two first structural layers 62 are spaced apart, and each first structural layer 62 is surrounded by the second structural layer 61.

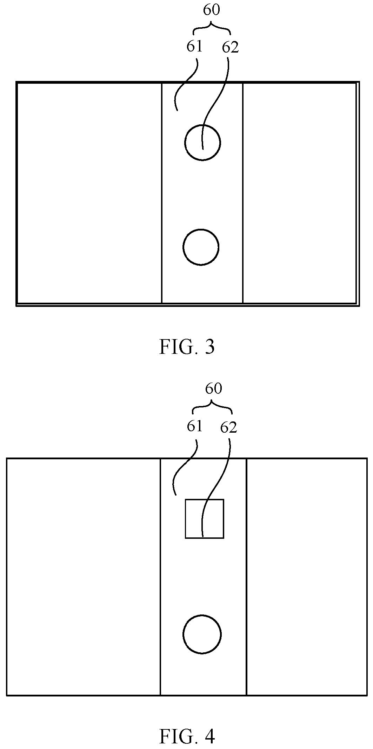

FIG. 3 shows a top view of another gate structural layer. The second structural layer 61 wraps the first structural layer 62, the first structural layer 62 is located in the middle of the gate structural layer 60, and the second structural layer 61 is located on the periphery of the gate structural layer 60. There are two first structural layers 62, and each first structural layer 62 is a circular structure. When the two first structural layers 62 are specifically disposed, the two first structural layers 62 are spaced apart, and each first structural layer 62 is surrounded by the second structural layer 61.

FIG. 4 shows a top view of another gate structural layer 60. The second structural layer 61 wraps the first structural layer 62, the first structural layer 62 is located in the middle of the gate structural layer 60, and the second structural layer 61 is located on the periphery of the gate structural layer 60. There are two first structural layers 62, and one of the first structural layers 62 is circular, and the other one of the first structural layers 62 is rectangular. When the two first structural layers 62 are specifically disposed, the two first structural layers 62 are spaced apart, and each first structural layer 62 is surrounded by the second structural layer 61.

It can be learned from FIG. 2, FIG. 3, and FIG. 4 that the first structural layer 62 provided in this embodiment of this application may use columnar structures with different cross-sectional shapes. FIG. 2, FIG. 3, and FIG. 4 merely specifically illustrate several specific cross-sectional shapes of the first structural layer 62. Other shapes may be alternatively selected for the cross-section of the first structural layer 62 provided in this embodiment of this application. This is not specifically limited herein.

It should be understood that, in this embodiment of this application, a quantity of first structural layers 62 is not limited. In addition to the two first structural layers 62 shown in FIG. 2, FIG. 3, or FIG. 4, different quantities of first structural layers 62, such as one, three, or four, may be used. Specifically, a quantity of the first structural layers 62 may be set based on a requirement.

In addition, when a plurality of first structural layers 62 are used, arrangement of the first structural layers 62 is not specifically limited in this embodiment of this application. The first structural layers 62 may be arranged in different arrangement manners such as a single-row arrangement, an array arrangement, a triangular arrangement, an X-shaped arrangement, or a circular arrangement. It is only necessary to ensure that ohmic contact with the gate metal layer 70 is achieved.

In an optional solution, a proportion of the cross-sectional area of the first structural layer 62 to the cross-sectional area of the gate structure 60 is between 5% and 50%. For example, the proportion of the cross-sectional area of the first structural layer 62 to the cross-sectional area of the gate structure 60 may be any proportion of 5%, 10%, 15%, 25%, 30%, 35%, 50%, or the like. It should be understood that, when there are a plurality of first structural layers 62, the cross-sectional area of the first structural layers 62 refers to a sum of the cross-sectional areas of all the first structural layers 62.

It can be learned from the foregoing description that, in the hybrid gate field effect transistor provided in this embodiment of this application, the gate structural layer 60 of the hybrid gate field effect transistor is formed by using the first structural layer 62 and the second structural layer 61. In this way, the gate metal layer 70 is connected to the gate structural layer 60 in an ohmic contact manner with relatively small resistance, to improve the reliability of the hybrid gate field effect transistor.

To facilitate understanding of the hybrid gate field effect transistor provided in this embodiment of this application, the following describes in detail a method for preparing the hybrid gate field effect transistor with reference to the accompanying drawings. In embodiments of this application, the hybrid gate field effect transistor may be prepared by using different preparation methods, which are described below one by one.

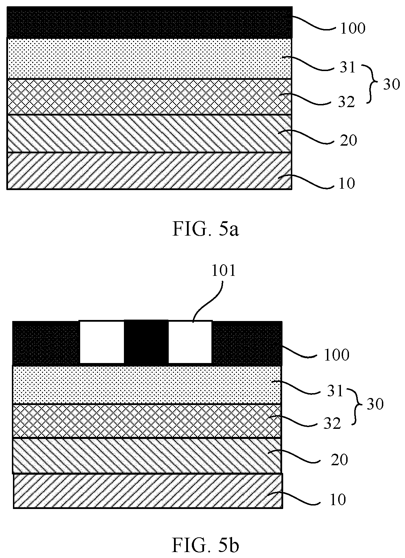

First, FIG. 5a to FIG. 5g show a specific method for preparing a hybrid gate field effect transistor. The method includes the following steps.

Step 001: Form an etching layer on a channel layer.

With reference to FIG. 5a, a substrate 10, a buffer layer 20, a gallium nitride layer 32, and an aluminum gallium nitride barrier layer 31 are formed through stacking by using processes such as epitaxial growth and deposition. When the etching layer 100 is formed on the aluminum gallium nitride barrier layer 31, the etching layer 100 may be directly formed on the aluminum gallium nitride barrier layer 31 in a manner such as coating or deposition. It should be understood that, a thickness of the etching layer 100 should be no less than a thickness of a gate structural layer 60.

Step 002: Etch an annular hole in the etching layer.

With reference to FIG. 5b, the annular hole 101 is formed in the etching layer 100 by using an etching process, and the annular hole 101 runs through the etching layer 100, so that the aluminum gallium nitride barrier layer 31 is exposed in the annular hole 101. A shape of the annular hole 101 matches that of a second structural layer 61, and is used to form the second structural layer 61 in the annular hole 101. In addition, a shape of a physical structure (the residual etching layer 100) in the annular hole 101 matches that of the first structural layer 62, to form the second structural layer 61, leaving space to the first structural layer 62.

Step 003: Form the second structural layer in the annular hole.

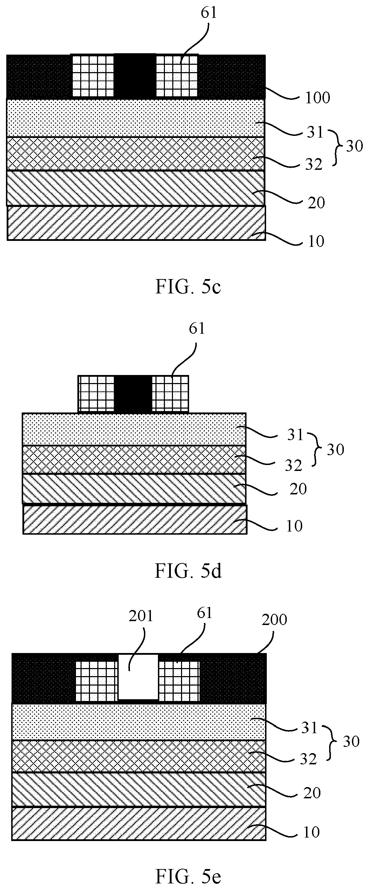

With reference to FIG. 5c, the second structural layer 61 is formed in the annular hole 101 in manners such as epitaxial growth and deposition. The formed second structural layer 61 is in contact with the aluminum gallium nitride barrier layer 31.

Step 004: Etch a through hole in the etching layer.

With reference to FIG. 5d, the etching layer 100 on the periphery of the second structural layer 61 is etched off, and only the etching layer located in the second structural layer 61 is retained. With reference to FIG. 5e, a new etching layer 200 is formed. The newly formed etching layer 200 covers the second structural layer 61 and the residual structure of the original etching layer 100. Etching is performed in the newly formed etching layer 200 to form the through hole 201. The through hole 201 is located in the second structural layer 61. In addition, an inner side wall of the second structural layer 61 is used as a side wall of the through hole 201, and a top surface of the aluminum gallium nitride barrier layer 31 is used as a bottom wall of the through hole 201.

Step 005: Form the first structural layer in the through hole.

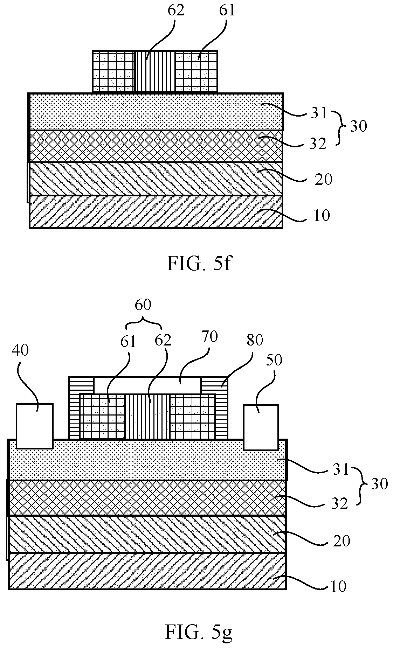

With reference to FIG. 5f, the first structural layer 62 is formed in the through hole in a manner such as epitaxial growth or deposition. The first structural layer 62 is separately in contact with the second structural layer 61 and the aluminum gallium nitride barrier layer 31.

In addition, when the first structural layer 62 is formed, because the newly formed etching layer covers the second structural layer 61, the formed first structural layer 62 does not cover the second structural layer 61. After preparation, the first structural layer 62 and the second structural layer 61 are disposed in a same layer, and the second structural layer 61 wraps the first structural layer 62.

After the first structural layer 62 is formed, a remaining part of the etching layer is etched off, so that the gate structural layer 60 including the first structural layer 62 and the second structural layer 61 is exposed.

Step 006: Form another layer structure on the channel layer.

With reference to FIG. 5g, a source 40 and a drain 50 are formed on the channel layer 30. Specifically, the source 40 and the drain 50 may be formed on the aluminum gallium nitride barrier layer 31 by using a process such as deposition or epitaxial growth.

First, a passivation layer 80 is prepared, the passivation layer 80 is etched to form through holes corresponding to the source 40, the drain 50, and the gate metal layer 70, and the gate metal layer 70, the source 40, and the drain 50 are respectively formed in the through holes. The formed gate metal layer 70 is in ohmic contact with the first structural layer 62 and in Schottky contact with the second structural layer 61.

It can be learned from the foregoing preparation process that, the gate structural layer 60 may be formed by using processes of etching and deposition. In addition, the gate structural layer 60 of the hybrid gate field effect transistor is formed by using the first structural layer 62 and the second structural layer 61, so that the gate metal layer 70 is connected to the gate structural layer 60 in an ohmic contact manner with small resistance, thereby improving reliability of the hybrid gate field effect transistor.

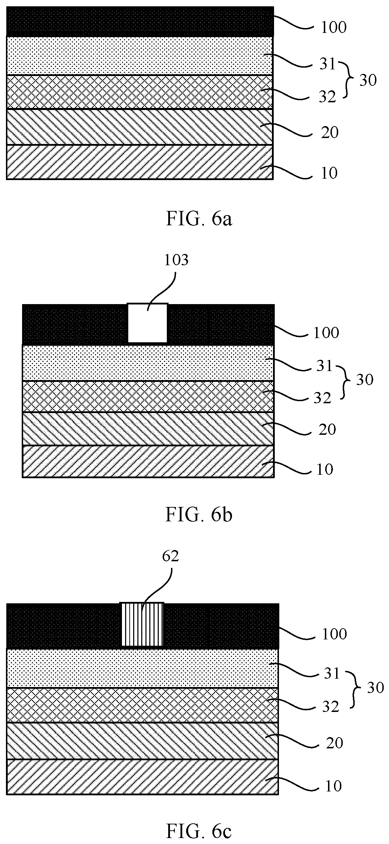

FIG. 6a to FIG. 6g show another specific method for preparing a hybrid gate field effect transistor. The method includes the following steps.

Step 001: Form an etching layer on a channel layer.

With reference to FIG. 6a, a substrate 10, a buffer layer 20, a gallium nitride layer 32, and an aluminum gallium nitride barrier layer 31 are formed through stacking by using processes such as epitaxial growth and deposition. When the etching layer 100 is formed on the aluminum gallium nitride barrier layer 31, the etching layer 100 may be directly formed on the aluminum gallium nitride barrier layer 31 in a manner such as coating or deposition. It should be understood that, a thickness of the etching layer 100 should be no less than a thickness of a gate structural layer 60.

Step 002: Etch a through hole in the etching layer.

With reference to FIG. 6b, the through hole 103 is formed in the etching layer 100 by using an etching process, and the through hole 103 runs through the etching layer 100, so that the aluminum gallium nitride barrier layer 31 is exposed in the through hole 103. A shape of the through hole 103 matches that of a first structural layer 62, and the remaining etching layer is used to form the first structural layer 62 in the through hole 103.

Step 003: Form the first structural layer in the through hole.

With reference to FIG. 6c, the first structural layer 62 is formed in the through hole 103 in manners such as epitaxial growth and deposition. The formed first structural layer 62 is in contact with the aluminum gallium nitride barrier layer 31.

Step 004: Etch an annular hole in the etching layer.

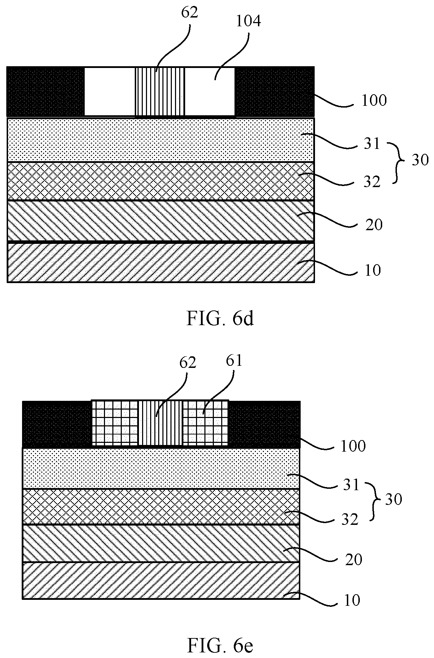

With reference to FIG. 6d, the etching layer 100 on the periphery of the first structural layer 62 is etched off, to form the annular hole 104. An outer side wall of the first structural layer 62 is exposed in the annular hole 104, so that a subsequently prepared second structural layer 61 is in contact with the first structural layer 62.

Step 005: Form the second structural layer in the annular hole.

With reference to FIG. 6e, the second structural layer 61 is formed in the annular hole 104 in a manner such as epitaxial growth or deposition. The second structural layer 61 is separately in contact with the first structural layer 62 and the aluminum gallium nitride barrier layer 31.

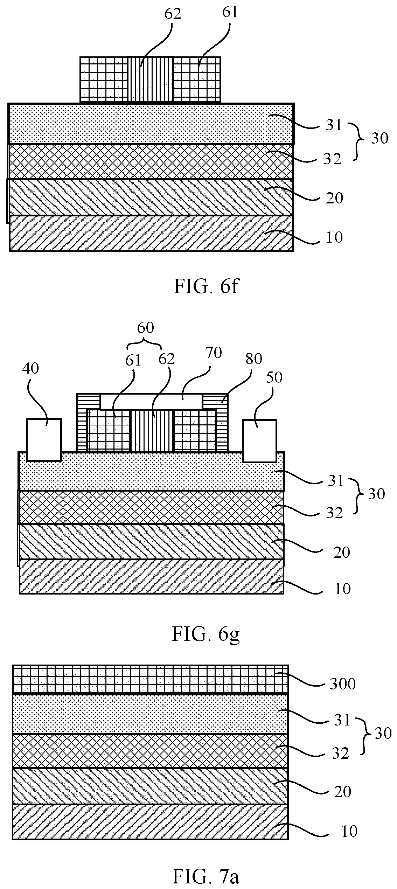

With reference to FIG. 6f, after the second structural layer 61 is formed, a remaining part of the etching layer 100 is etched off, so that the gate structural layer 60 including the first structural layer 62 and the second structural layer 61 is exposed.

Step 006: Form another layer structure on the channel layer.

With reference to FIG. 6g, a source 40 and a drain 50 are formed on the channel layer 30. Specifically, the source 40 and the drain 50 may be formed on the aluminum gallium nitride barrier layer 31 by using a process such as deposition or epitaxial growth.

First, a passivation layer 80 is prepared, the passivation layer 80 is etched to form through holes 103 corresponding to the source 40, the drain 50, and the gate metal layer 70, and the gate metal layer 70, the source 40, and the drain 50 are respectively formed in the through holes 103. The formed gate metal layer 70 is in ohmic contact with the first structural layer 62 and in Schottky contact with the second structural layer 61.

It can be learned from the foregoing preparation process that, the gate structural layer 60 may be formed by using processes of etching and deposition. In addition, the gate structural layer 60 of the hybrid gate field effect transistor is formed by using the first structural layer 62 and the second structural layer 61, so that the gate metal layer 70 is connected to the gate structural layer 60 in an ohmic contact manner with small resistance, thereby improving reliability of the hybrid gate field effect transistor.

FIG. 7a to FIG. 7d show another specific method for preparing a hybrid gate field effect transistor. The method includes the following steps.

Step 001: Form, on a channel layer, a material layer with a same material as that of a second structural layer.

With reference to FIG. 7a, a substrate 10, a buffer layer 20, a gallium nitride layer 32, and an aluminum gallium nitride barrier layer 31 are formed through stacking by using processes such as epitaxial growth and deposition. When the material layer 300 is formed on the aluminum gallium nitride barrier layer 31, the material layer 300 may be directly formed on the aluminum gallium nitride barrier layer 31 in a manner such as epitaxial growth or deposition. It should be understood that, a thickness of the material layer 300 should be no less than a thickness of a gate structural layer 60.

Step 002: Etch the material layer to form the second structural layer.

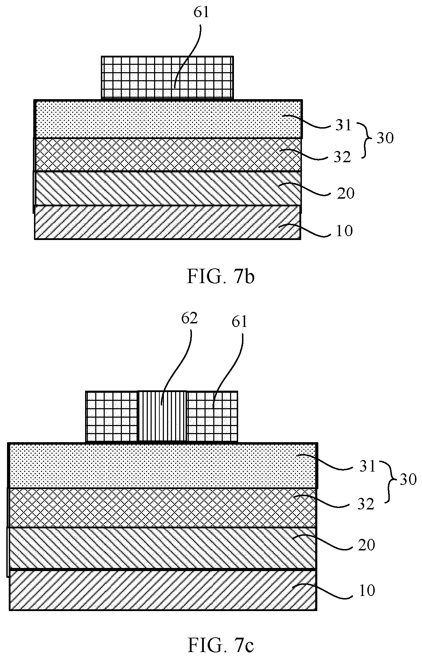

With reference to FIG. 7b, the second structural layer 61 with a same size as the gate structural layer 60 is formed by etching the material layer 300.

Step 003: Form the first structural layer through ion injection.

With reference to FIG. 7c, the first structural layer 62 is formed in a manner of injecting counter ions in the second structural layer 61, a part in which counter ions are injected in the second structural layer 61 is used as the first structural layer 62, and a part in which no counter ion is injected is used as the second structural layer 61 of the gate structural layer 60. The second structural layer 61 wraps the first structural layer 62, and for a shape of the formed first structural layer 62, refer to the related description in FIG. 2 to FIG. 4.

Step 004: Form another layer structure on the channel layer.

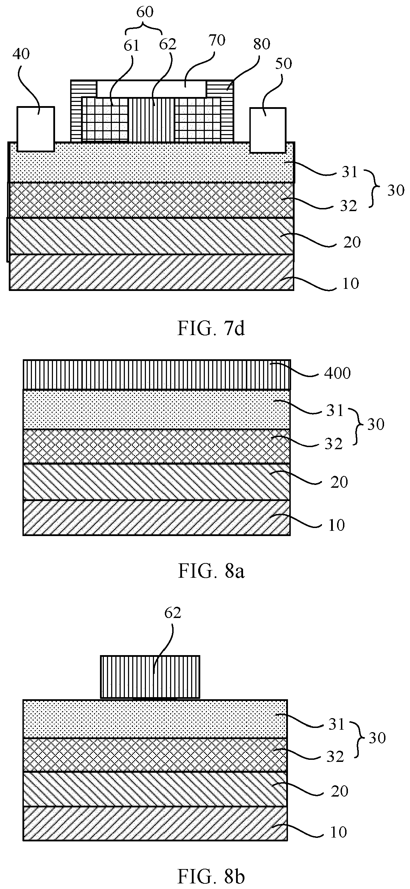

With reference to FIG. 7d, a source 40 and a drain 50 are formed on the channel layer 30. Specifically, the source 40 and the drain 50 may be formed on the aluminum gallium nitride barrier layer 31 by using a process such as deposition or epitaxial growth.

First, a passivation layer 80 is prepared, the passivation layer 80 is etched to form through holes corresponding to the source 40, the drain 50, and the gate metal layer 70, and the gate metal layer 70, the source 40, and the drain 50 are respectively formed in the through holes. The formed gate metal layer 70 is in ohmic contact with the first structural layer 62 and in Schottky contact with the second structural layer 61.

It can be learned from the foregoing preparation process that, the gate structural layer 60 may be formed by using an ion injection process. In addition, the gate structural layer 60 of the hybrid gate field effect transistor is formed by using the first structural layer 62 and the second structural layer 61, so that the gate metal layer 70 is connected to the gate structural layer 60 in an ohmic contact manner with small resistance, thereby improving reliability of the hybrid gate field effect transistor.

FIG. 8a to FIG. 8d show another specific method for preparing a hybrid gate field effect transistor. The method includes the following steps.

Step 001: Form, on a channel layer, a material layer with a same material as that of a first structural layer.

With reference to FIG. 8a, a substrate 10, a buffer layer 20, a gallium nitride layer 32, and an aluminum gallium nitride barrier layer 31 are formed through stacking by using processes such as epitaxial growth and deposition. When the material layer 400 is formed on the aluminum gallium nitride barrier layer 31, the material layer 400 may be directly formed on the aluminum gallium nitride barrier layer 31 in a manner such as epitaxial growth or deposition. It should be understood that, a thickness of the material layer 400 should be no less than a thickness of a gate structural layer 60.

Step 002: Etch the material layer to form the first structural layer.

With reference to FIG. 8b, the first structural layer 62 with a same size as the gate structural layer 60 is formed by etching the material layer 400.

Step 003: Form the second structural layer through ion injection.

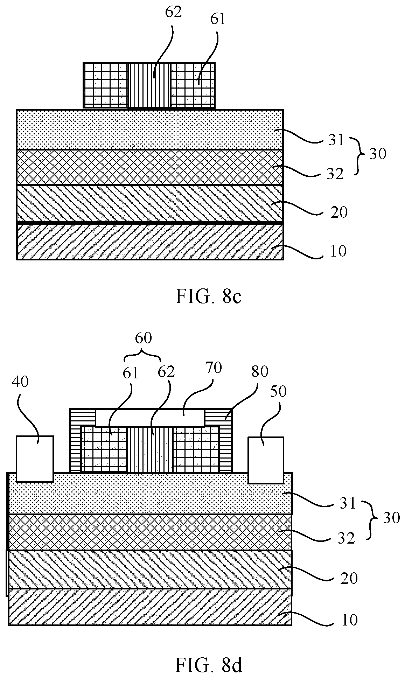

With reference to FIG. 8c, the second structural layer 61 is formed in a manner of injecting counter ions in the first structural layer 62, a part in which counter ions are injected in the first structural layer 62 is used as the second structural layer 61, and a part in which no counter ion is injected is used as the first structural layer 62 of the gate structural layer 60. The second structural layer 61 wraps the first structural layer 62, and for a shape of the formed first structural layer 62, refer to the related description in FIG. 2 to FIG. 4.

Step 004: Form another layer structure on the channel layer.

With reference to FIG. 8d, a source 40 and a drain 50 are formed on the channel layer 30. Specifically, the source 40 and the drain 50 may be formed on the aluminum gallium nitride barrier layer 31 by using a process such as deposition or epitaxial growth.

First, a passivation layer 80 is prepared, the passivation layer 80 is etched to form through holes corresponding to the source 40, the drain 50, and the gate metal layer 70, and the gate metal layer 70, the source 40, and the drain 50 are respectively formed in the through holes. The formed gate metal layer 70 is in ohmic contact with the first structural layer 62 and in Schottky contact with the second structural layer 61.

It can be learned from the foregoing preparation process that, the gate structural layer 60 may be formed by using an ion injection process. In addition, the gate structural layer 60 of the hybrid gate field effect transistor is formed by using the first structural layer 62 and the second structural layer 61, so that the gate metal layer 70 is connected to the gate structural layer 60 in an ohmic contact manner with small resistance, thereby improving reliability of the hybrid gate field effect transistor.

It can be learned from the foregoing description that, the hybrid gate field effect transistor provided in embodiments of this application may be prepared in different manners. In addition, in the formed hybrid gate field effect transistor, the gate structural layer 60 of the hybrid gate field effect transistor is formed by using the first structural layer 62 and the second structural layer 61, so that the gate metal layer 70 is connected to the gate structural layer 60 in an ohmic contact manner with small resistance, thereby improving reliability of the hybrid gate field effect transistor.

An embodiment of this application further provides a switch circuit. The switch circuit may be a switch circuit in an AC-DC conversion circuit, a high-voltage conversion circuit, or a half bridge rectifier circuit. The switch circuit includes a mainboard and the hybrid gate field effect transistor according to any one of the foregoing implementations that is disposed on the mainboard. It can be learned from the foregoing description that, in a manner of using the hybrid gate structure as the gate structural layer 60, the gate structural layer 60 is prepared by using two different materials, and the material located in the middle of the hybrid gate is in ohmic contact with the gate metal layer 70, to improve reliability of connection between the gate metal layer 70 and the gate structural layer 60, thereby improving reliability of the hybrid gate field effect transistor.

## Claims

1. A hybrid gate gallium nitride, GaN, field effect transistor, comprising: a channel layer (30), and a source (40), a drain (50), and a gate structure (60) that are stacked with the channel layer (30), wherein the source (40), the drain (50), and the gate structure (60) are disposed in a same layer;
the gate structure (60) comprises a first structural layer (62) and a second structural layer (61) that are disposed in a same layer and separately connected to the channel layer (30), and the second structural layer (61) wraps the first structural layer (62), wherein the first structural layer (62) is an N-type gallium nitride layer; and the second structural layer (61) is a P-type gallium nitride layer; and
the hybrid gate field effect transistor further comprises a gate metal layer (70), wherein the gate metal layer (70) is in ohmic contact with the first structural layer (62) and in Schottky contact with the second structural layer (61).

2. The hybrid gate field effect transistor according to claim 1, wherein the channel layer (30) comprises a gallium nitride layer (32) and an aluminum gallium nitride barrier layer (31) that are stacked; and
the source (40), the drain (50), and the gate structure (60) are disposed on the aluminum gallium nitride barrier layer (31).

3. The hybrid gate field effect transistor according to claim 2, further comprising a substrate (10) and a buffer layer (20) disposed on the substrate (10), wherein
the gallium nitride layer (32) is formed on the buffer layer (20).

4. The hybrid gate field effect transistor according to claim 3, wherein a material of the substrate (10) is one of silicon, sapphire, silicon carbide, and a gallium nitride material.

5. The hybrid gate field effect transistor according to any one of claims 2 to 4, further comprising a passivation layer (80), wherein the passivation layer (80) and the aluminum gallium nitride barrier layer (31) are stacked; and
the source (40), the drain (50), and the gate structure (60) run through the passivation layer (80), and are exposed outside the passivation layer (80).

6. The hybrid gate field effect transistor according to any one of claims 1 to 5, wherein the first structural layer (62) is cylindrical, square columnar, or cylindroid.

7. A method for preparing a hybrid gate gallium nitride, GaN, field effect transistor, wherein the method comprises the following steps:
forming a first structural layer (62) and a second structural layer (61) on a channel layer (30), wherein the first structural layer (62) and the second structural layer (61) are disposed in a same layer and separately connected to the channel layer (30), and the second structural layer (61) wraps the first structural layer (62); and the first structural layer (62) and the second structural layer (61) form a gate structure (60);
wherein the first structural layer (62) is an N-type gallium nitride layer; and the second structural layer (61) is a P-type gallium nitride layer;
forming a gate metal layer (70), wherein the gate metal layer (70) is in ohmic contact with the first structural layer (62) and in Schottky contact with the second structural layer (61); and
forming a source (40) and a drain (50) on the channel layer (30), wherein the source (40), the drain (50), and the gate structure (60) are disposed in a same layer.

8. The preparation method according to claim 7, wherein the forming a first structural layer (62) and a second structural layer (61) on a channel layer (30) is specifically:
forming an etching layer (100) on the channel layer (30);
etching an annular hole (101) in the etching layer (100);
forming the second structural layer (61) in the annular hole (101);
etching a through hole (201) in the etching layer (100), wherein an inner side wall of the second structural layer (61) is a side wall of the through hole (201);
forming the first structural layer (62) in the through hole (201), wherein the second structural layer (61) wraps the first structural layer (62); and
etching off a remaining part of the etching layer (100).

9. The preparation method according to claim 7, wherein the forming a first structural layer (62) and a second structural layer (61) on a channel layer (30) is specifically:
forming an etching layer (100) on the channel layer (30);
etching a through hole (103) in the etching layer (100);
forming the first structural layer (62) in the through hole (103);
etching an annular hole (104) in the etching layer (100), wherein an outer side wall of the first structural layer (62) is exposed outside the annular hole (104); and
forming the second structural layer (61) in the annular hole (104), wherein the second structural layer (61) wraps the first structural layer (62); and
etching off a remaining part of the etching layer (100).

10. The preparation method according to claim 7, wherein the forming a first structural layer (62) and a second structural layer (61) on a channel layer (30) is specifically:
forming, on the channel layer (30), a material layer (400) with a same material as that of the first structural layer (62);
etching the material layer (400) to form the first structural layer (62); and
forming the second structural layer (61) through ion injection, wherein the second structural layer (61) wraps the first structural layer (62).

11. The preparation method according to claim 7, wherein the forming a first structural layer (62) and a second structural layer (61) on a channel layer (30) is specifically:
forming, on the channel layer (30), a material layer (300) with a same material as that of the second structural layer (61);
etching the material layer (300) to form the second structural layer (61); and
forming the first structural layer (62) through ion injection, wherein the second structural layer (61) wraps the first structural layer (62).

12. The preparation method according to any one of claims 7 to 11, further comprising:
forming a buffer layer (20) on a substrate (10); and
forming the channel layer (30) on the buffer layer (20).

13. A switch circuit, comprising a mainboard and the hybrid gate field effect transistor according to any one of claims 1 to 6 that is disposed on the mainboard.

## Patentansprüche

1. Hybrid-Gate-Galliumnitrid-Feldeffekttransistor, Hybrid-Gate-GaN-Feldeffekttransistor, umfassend: eine Kanalschicht (30) und eine Source (40), einen Drain (50) und eine Gate-Struktur (60), die mit der Kanalschicht (30) gestapelt sind, wobei die Source (40), der Drain (50) und die Gate-Struktur (60) in einer selben Schicht angeordnet sind;
die Gate-Struktur (60) eine erste strukturelle Schicht (62) und eine zweite strukturelle Schicht (61) umfasst, die in einer selben Schicht angeordnet und separat mit der Kanalschicht (30) verbunden sind, und die zweite strukturelle Schicht (61) die erste strukturelle Schicht (62) umhüllt, wobei die erste strukturelle Schicht (62) eine N-Typ-Galliumnitrid-Schicht ist; und die zweite strukturelle Schicht (61) eine P-Typ-Galliumnitrid-Schicht ist; und
der Hybrid-Gate-Feldeffekttransistor ferner eine Gate-Metallschicht (70) umfasst, wobei die Gate-Metallschicht (70) in ohmschem Kontakt mit der ersten strukturellen Schicht (62) und in Schottky-Kontakt mit der zweiten strukturellen Schicht (61) steht.

2. Hybrid-Gate-Feldeffekttransistor nach Anspruch 1, wobei die Kanalschicht (30) eine Galliumnitrid-Schicht (32) und eine Aluminium-Galliumnitrid-Sperrschicht (31) umfasst, die gestapelt sind; und
die Source (40), der Drain (50) und die Gate-Struktur (60) auf der Aluminium-Galliumnitrid-Sperrschicht (31) angeordnet sind.

3. Hybrid-Gate-Feldeffekttransistor nach Anspruch 2, ferner umfassend ein Substrat (10) und eine Pufferschicht (20), die auf dem Substrat (10) angeordnet ist, wobei
die Galliumnitrid-Schicht (32) auf der Pufferschicht (20) gebildet ist.

4. Hybrid-Gate-Feldeffekttransistor nach Anspruch 3, wobei ein Material des Substrats (10) eines aus Silizium, Saphir, Siliziumkarbid und einem Galliumnitridmaterial ist.

5. Hybrid-Gate-Feldeffekttransistor nach einem der Ansprüche 2 bis 4, ferner umfassend eine Passivierungsschicht (80), wobei die Passivierungsschicht (80) und die Aluminium-Galliumnitrid-Sperrschicht (31) gestapelt sind; und
die Source (40), der Drain (50) und die Gate-Struktur (60) durch die Passivierungsschicht (80) verlaufen und außerhalb der Passivierungsschicht (80) freiliegen.

6. Hybrid-Gate-Feldeffekttransistor nach einem der Ansprüche 1 bis 5, wobei die erste strukturelle Schicht (62) zylindrisch, quadratisch säulenförmig oder zylindroid ist.

7. Verfahren zum Fertigen eines Hybrid-Gate-Galliumnitrid-Feldeffekttransistors, Hybrid-Gate-GaN-Feldeffekttransistors, wobei das Verfahren die folgenden Schritte umfasst:
Bilden einer ersten strukturellen Schicht (62) und einer zweiten strukturellen Schicht (61) auf einer Kanalschicht (30), wobei die erste strukturelle Schicht (62) und die zweite strukturelle Schicht (61) in einer selben Schicht angeordnet und separat mit der Kanalschicht (30) verbunden sind und die zweite strukturelle Schicht (61) die erste strukturelle Schicht (62) umhüllt; und die erste strukturelle Schicht (62) und die zweite strukturelle Schicht (61) eine Gate-Struktur (60) bilden;
wobei die erste strukturelle Schicht (62) eine N-Typ-Galliumnitrid-Schicht ist; und die zweite strukturelle Schicht (61) eine P-Typ-Galliumnitrid-Schicht ist;
Bilden einer Gate-Metallschicht (70), wobei die Gate-Metallschicht (70) in ohmschem Kontakt mit der ersten strukturellen Schicht (62) und in Schottky-Kontakt mit der zweiten strukturellen Schicht (61) steht; und
Bilden einer Source (40) und eines Drains (50) auf der Kanalschicht (30), wobei die Source (40), der Drain (50) und die Gate-Struktur (60) in einer selben Schicht angeordnet sind.

8. Fertigungsverfahren nach Anspruch 7, wobei das Bilden einer ersten strukturellen Schicht (62) und einer zweiten strukturellen Schicht (61) auf einer Kanalschicht (30) insbesondere Folgendes bedeutet:
Bilden einer Ätzschicht (100) auf der Kanalschicht (30);
Ätzen eines ringförmigen Lochs (101) in die Ätzschicht (100);
Bilden der zweiten strukturellen Schicht (61) in dem ringförmigen Loch (101);
Ätzen eines Durchgangslochs (201) in die Ätzschicht (100), wobei eine innere Seitenwand der zweiten strukturellen Schicht (61) eine Seitenwand des Durchgangslochs (201) ist;
Bilden der ersten strukturellen Schicht (62) in dem Durchgangsloch (201), wobei die zweite strukturelle Schicht (61) die erste strukturelle Schicht (62) umhüllt; und
Wegätzen eines verbleibenden Teils der Ätzschicht (100).

9. Fertigungsverfahren nach Anspruch 7, wobei das Bilden einer ersten strukturellen Schicht (62) und einer zweiten strukturellen Schicht (61) auf einer Kanalschicht (30) insbesondere Folgendes bedeutet:
Bilden einer Ätzschicht (100) auf der Kanalschicht (30);
Ätzen eines Durchgangslochs (103) in die Ätzschicht (100);
Bilden der ersten strukturellen Schicht (62) in dem Durchgangsloch (103);
Ätzen eines ringförmigen Lochs (104) in die Ätzschicht (100), wobei eine äußere Seitenwand der ersten strukturellen Schicht (62) außerhalb des ringförmigen Lochs (104) freiliegt; und
Bilden der zweiten strukturellen Schicht (61) in dem ringförmigen Loch (104), wobei die zweite strukturelle Schicht (61) die erste strukturelle Schicht (62) umhüllt; und
Wegätzen eines verbleibenden Teils der Ätzschicht (100).

10. Fertigungsverfahren nach Anspruch 7, wobei das Bilden einer ersten strukturellen Schicht (62) und einer zweiten strukturellen Schicht (61) auf einer Kanalschicht (30) insbesondere Folgendes bedeutet:
Bilden, auf der Kanalschicht (30), einer Materialschicht (400) mit einem gleichen Material wie demjenigen der ersten strukturellen Schicht (62);
Ätzen der Materialschicht (400), um die erste strukturelle Schicht (62) zu bilden; und
Bilden der zweiten strukturellen Schicht (61) durch Ioneninjektion, wobei die zweite strukturelle Schicht (61) die erste strukturelle Schicht (62) umhüllt.

11. Fertigungsverfahren nach Anspruch 7, wobei das Bilden einer ersten strukturellen Schicht (62) und einer zweiten strukturellen Schicht (61) auf einer Kanalschicht (30) insbesondere Folgendes bedeutet:
Bilden, auf der Kanalschicht (30), einer Materialschicht (300) mit einem gleichen Material wie demjenigen der zweiten strukturellen Schicht (61);
Ätzen der Materialschicht (300), um die zweite strukturelle Schicht (61) zu bilden; und
Bilden der ersten strukturellen Schicht (62) durch Ioneninjektion, wobei die zweite strukturelle Schicht (61) die erste strukturelle Schicht (62) umhüllt.

12. Fertigungsverfahren nach einem der Ansprüche 7 bis 11, ferner umfassend:
Bilden einer Pufferschicht (20) auf einem Substrat (10); und
Bilden der Kanalschicht (30) auf der Pufferschicht (20).

13. Schaltkreis, umfassend eine Hauptplatine und den Hybrid-Gate-Feldeffekttransistor nach einem der Ansprüche 1 bis 6, der auf der Hauptplatine angeordnet ist.

## Revendications

1. Transistor à effet de champ à grille hybride de nitrure de gallium, GaN, comprenant : une couche de canal (30), et une source (40), un drain (50), et une structure de grille (60) qui sont empilés avec la couche de canal (30), dans lequel la source (40), le drain (50), et la structure de grille (60) sont disposés dans une même couche ;
la structure de grille (60) comprend une première couche structurelle (62) et une seconde couche structurelle (61) qui sont disposées dans une même couche et connectées séparément à la couche de canal (30), et la seconde couche structurelle (61) enveloppe la première couche structurelle (62), dans lequel la première couche structurelle (62) est une couche de nitrure de gallium de type N ; et la seconde couche structurelle (61) est une couche de nitrure de gallium de type P ; et
le transistor à effet de champ à grille hybride comprend également une couche métallique de grille (70), dans lequel la couche métallique de grille (70) est en contact ohmique avec la première couche structurelle (62) et en contact Schottky avec la seconde couche structurelle (61).

2. Transistor à effet de champ à grille hybride selon la revendication 1, dans lequel la couche de canal (30) comprend une couche de nitrure de gallium (32) et une couche barrière de nitrure d'aluminium et de gallium (31) qui sont empilées ; et
la source (40), le drain (50), et la structure de grille (60) sont disposés sur la couche barrière de nitrure d'aluminium et de gallium (31).

3. Transistor à effet de champ à grille hybride selon la revendication 2, comprenant également un substrat (10) et une couche tampon (20) disposée sur le substrat (10), dans lequel la couche de nitrure de gallium (32) est formée sur la couche tampon (20).

4. Transistor à effet de champ à grille hybride selon la revendication 3, dans lequel un matériau du substrat (10) est un matériau parmi le silicium, le saphir, le carbure de silicium, et un matériau en nitrure de gallium.

5. Transistor à effet de champ à grille hybride selon l'une quelconque des revendications 2 à 4, comprenant également une couche de passivation (80), dans lequel la couche de passivation (80) et la couche barrière de nitrure d'aluminium et de gallium (31) sont empilées ; et
la source (40), le drain (50), et la structure de grille (60) traversent la couche de passivation (80), et sont exposés à l'extérieur de la couche de passivation (80).

6. Transistor à effet de champ à grille hybride selon l'une quelconque des revendications 1 à 5, dans lequel la première couche structurelle (62) est cylindrique, en forme de colonne carrée, ou cylindroïde.

7. Procédé de préparation d'un transistor à effet de champ à grille hybride de nitrure de gallium, GaN, dans lequel le procédé comprend les étapes suivantes :
la formation d'une première couche structurelle (62) et d'une seconde couche structurelle (61) sur une couche de canal (30), dans lequel la première couche structurelle (62) et la seconde couche structurelle (61) sont disposées dans une même couche et connectées séparément à la couche de canal (30), et la seconde couche structurelle (61) enveloppe la première couche structurelle (62) ; et la première couche structurelle (62) et la seconde couche structurelle (61) forment une structure de grille (60) ;
dans lequel la première couche structurelle (62) est une couche de nitrure de gallium de type N ; et la seconde couche structurelle (61) est une couche de nitrure de gallium de type P ;
la formation d'une couche métallique de grille (70), dans lequel la couche métallique de grille (70) est en contact ohmique avec la première couche structurelle (62) et en contact Schottky avec la seconde couche structurelle (61) ; et
la formation d'une source (40) et d'un drain (50) sur la couche de canal (30), dans lequel la source (40), le drain (50), et la structure de grille (60) sont disposés dans une même couche.

8. Procédé de préparation selon la revendication 7, dans lequel la formation d'une première couche structurelle (62) et d'une seconde couche structurelle (61) sur une couche de canal (30) est constituée spécifiquement des étapes suivantes :
la formation d'une couche de gravure (100) sur la couche de canal (30) ;
la gravure d'un trou annulaire (101) dans la couche de gravure (100) ;
la formation de la seconde couche structurelle (61) dans le trou annulaire (101) ;
la gravure d'un trou traversant (201) dans la couche de gravure (100), dans lequel une paroi latérale interne de la seconde couche structurelle (61) est une paroi latérale du trou traversant (201) ;
la formation de la première couche structurelle (62) dans le trou traversant (201), dans lequel la seconde couche structurelle (61) enveloppe la première couche structurelle (62) ; et
la gravure d'une partie restante de la couche de gravure (100).

9. Procédé de préparation selon la revendication 7, dans lequel la formation d'une première couche structurelle (62) et d'une seconde couche structurelle (61) sur une couche de canal (30) est constituée spécifiquement des étapes suivantes :
la formation d'une couche de gravure (100) sur la couche de canal (30) ;
la gravure d'un trou traversant (103) dans la couche de gravure (100) ;
la formation de la première couche structurelle (62) dans le trou traversant (103) ;
la gravure d'un trou annulaire (104) dans la couche de gravure (100), dans lequel une paroi latérale extérieure de la première couche structurelle (62) est exposée à l'extérieur du trou annulaire (104) ; et
la formation de la seconde couche structurelle (61) dans le trou annulaire (104), dans lequel la seconde couche structurelle (61) enveloppe la première couche structurelle (62) ; et
la gravure d'une partie restante de la couche de gravure (100).

10. Procédé de préparation selon la revendication 7, dans lequel la formation d'une première couche structurelle (62) et d'une seconde couche structurelle (61) sur une couche de canal (30) est constituée spécifiquement des étapes suivantes :
la formation, sur la couche de canal (30), d'une couche de matériau (400) avec un même matériau que celui de la première couche structurelle (62) ;
la gravure de la couche de matériau (400) pour former la première couche structurelle (62) ; et
la formation de la seconde couche structurelle (61) par injection d'ions, dans lequel la seconde couche structurelle (61) enveloppe la première couche structurelle (62).

11. Procédé de préparation selon la revendication 7, dans lequel la formation d'une première couche structurelle (62) et d'une seconde couche structurelle (61) sur une couche de canal (30) est constituée spécifiquement des étapes suivantes :
la formation, sur la couche de canal (30), d'une couche de matériau (300) avec un même matériau que celui de la seconde couche structurelle (61) ;
la gravure de la couche de matériau (300) pour former la seconde couche structurelle (61) ; et
la formation de la première couche structurelle (62) par injection d'ions, dans lequel la seconde couche structurelle (61) enveloppe la première couche structurelle (62).

12. Procédé de préparation selon l'une quelconque des revendications 7 à 11, comprenant également :
la formation d'une couche tampon (20) sur un substrat (10) ; et
la formation de la couche de canal (30) sur la couche tampon (20).

13. Circuit de commutateur, comprenant une carte mère et le transistor à effet de champ à grille hybride selon l'une quelconque des revendications 1 à 6 qui est disposé sur la carte mère.
